# EUROPEAN PATENT SPECIFICATION

(11) **EP 0 545 777 B1**
(45) Date of publication and mention of the grant of the patent: **30.09.1998**
(21) Application number: 92403170.1
(22) Date of filing: 25.11.1992
(51) Int. Cl.: H01L 39/24

(54) **Method for manufacturing superconducting thin film formed of oxide superconductor having a portion of a reduced thickness, superconducting thin film manufactured thereby, and superconducting device utilizing the superconducting thin film**
Verfahren zum Herstellen einer supraleitenden Dünnschicht mit einer Stelle reduzierter Schichtdicke und supraleitendes Bauelement, das eine derartige supraleitende Dünnschicht enthält
Méthode pour la fabrication d'un couche mince en matériau supraconducteur ayant un portion à épaisseur réduite de film supraconducteur et le dispositif supraconducteur utilisant ce film supraconducteur

(30) Priority: 30.11.1991 JP 342466/91
(43) Date of publication of application: 09.06.1993
(73) Proprietor: Sumitomo Electric Industries, Ltd., Osaka 541 (JP)
(72) Inventor: Tanaka, So, c/o Osaka Works of Sumitomo, Konohana-ku, Osaka (JP); Iiyama, Michitomo, c/o Osaka Works of Sumitomo, Konohana-ku, Osaka (JP)
(74) Representative: Bernasconi, Jean

(56) References cited:
- EP-A- 291 050
- EP-A- 325 765
- EP-A- 364 101
- WO-A-90/00816
- WO-A-92/15406
- DE-A- 4 109 766
- PROCEEDINGS OF THE SPIE, vol.247, 1991, pages 205-208, New York, US; Bourne L.C. et al:"High-temperature superconducting Josephson mixers from deliberate grain boundaries in Tl2CaBa2Cu2O8"

## Description

### Background of the Invention

### Field of the invention

The present invention relates to a method for manufacturing a superconducting thin film, to a superconducting thin film and a superconducting device, and more specifically to a method for manufacturing a superconducting thin film having a portion of a reduced thickness, a superconducting thin film manufactured thereby and a superconducting device which utilizes the superconducting thin film.

### Description of related art

Oxide superconductors which has been recently advanced in study have higher critical temperatures than those of metal superconductors, so that they are more practical. For example, Y-Ba-Cu-O type oxide superconductor has a critical temperature higher than 80 K and it is announced that Bi-Sr-Ca-Cu-O type oxide superconductor and Tl-Ba-Ca-Cu-O type oxide superconductor have critical temperatures higher than 100 K.

In order to produce superconducting devices which utilize an oxide superconductor, it is necessary to form an oxide superconductor thin film. The superconductor thin film is usually deposited on a single crystalline substrate, for example MgO, SrTiO₃ etc., by a sputtering, an MBE (molecular beam epitaxy), a CVD (chemical vapor deposition). The superconductor thin film grows epitaxially on this substrate.

In the prior art (see in particular EP-A-0 477 063), there has been proposed an oxide superconductor thin film which is deposited on a substrate having a projecting portion or a step portion on its principal surface. This type of the oxide superconductor thin film is often utilized for a weak-link type Josephson device and an FET type superconducting device having a superconducting channel. For example, the oxide superconductor has a planar upper surface so that the portion on the projecting portion of the substrate has a reduced thickness, in which a weak-link of a Josephson junction is formed or which constitutes the superconducting channel. Another example of the oxide superconductor thin film is an oxide superconductor thin film formed on the substrate having a step portion, in which a weak-link of a Josephson junction is formed at the step portion.

Previously, the projecting portion and the step portion of the substrate were formed by a photo-lithography process utilizing photoresist. Therefore, the principal surface of the substrate might be sometimes contaminated by the photoresist or the photoresist remover or it sometimes might react with the photoresist remover. A trace of the photoresist or the photoresist remover might remain on the substrate.

The oxide superconductor thin film deposited on the contaminated or reacted substrate had low crystallinity so as to have a low critical current density. Therefore, it was not practical to form the oxide superconductor thin film on the processed substrate. In addition, the oxide superconductor might react with the remaining photoresist or photoresist remover, so that the properties of the oxide superconductor thin films were substantially deteriorated.

### Summary of the Invention

Accordingly, it is an object of the present invention to provide a method for manufacturing a superconducting thin film, which overcomes the above mentioned defects of the conventional ones.

Another object of the present invention is to provide a superconducting thin film, which overcomes the above mentioned defects of the conventional ones.

Still another object of the present invention is to provide a superconducting device, which overcomes the above mentioned defects of the conventional ones.

The above and other objects of the present invention are achieved in accordance with the present invention by a method for manufacturing a superconducting thin film having at least one reduced thickness portion, the method comprising the steps of ion-implanting onto a principal surface of a crystalline substrate thereby forming a lattice defect at and below the principal surface of the substrate, etching the principal surface of the substrate by a wet-etching process so that the portion of the lattice defect is hardly etched thereby forming a projecting portion having a crystallographically specified shape; and forming an oxide superconductor thin film having a planar upper surface on the etched principal surface of the substrate so that a portion of the oxide superconductor thin film at the projecting portion of the substrate has a reduced thickness.

In order to form a projecting portion of the substrate, the method in accordance with the present invention utilizes a property of a crystalline substrate that a lattice defect portion has difficulty against etching, especially against wet-etching process. Therefore, the projecting portion can be called an "artificial etch projection". In this connection, there should be no lattice defect on a principal surface of the substrate excluding a portion which will become the projecting portion.

In a preferred embodiment, the substrate is heated under oxygen atmosphere at a temperature ranging from 1050 to 1500°C for 5 to 10 hours before the ion-implantation in order to eliminate lattice defects from its principal surface. One of the preferable conditions of the heat-treatment is that the temperature is 1100 °C and the duration time is 8 hours. If the substrate is heated at a temperature lower than 1050 °C, lattice defects of the principal surface cannot be eliminated enough. If the substrate is heated up to a temperature higher than 1500 °C, the principal surface is contaminated by vapor from a reactor.

According to the present invention, it is preferable that the ions which are implanted onto the principal surface of the substrate are selected from argon ions, neon ions and oxygen ions. A portion of a lattice defect on the principal surface of the substrate generated by ion-implantation of the specified ions is hardly etched so that the portion projects so as to form a quadrangular pyramid shape, when the substrate is etched by a wet-etching process. The projecting portion (artificial etch projection) is constituted, since the crystal structure of the portion is different from the other by the lattice defect. It is possible to form the substantially same size lined projecting portions by generating lined lattice defect portions formed by the ion-implantation. Therefore, according to the present invention, it is possible to manufacture integrated superconducting device of the same properties, simultaneously.

In a preferred embodiment, the ions are ion-implanted by a focused ion beam apparatus. It is also preferably that H₃PO₄ or HCI is used for the wet-etching process.

Crystallinity of the principal surface of the substrate may be degraded during the wet-etching process. Therefore, it is preferable that the substrate is heat-treated after the wet-etching process, again. The conditions of the heat-treatment are the same as those of the one which is carried out before the ion-implantation.

In a preferred embodiment, the oxide superconductor thin film is a *c*-axis orientated oxide superconductor thin film, since the *c*-axis orientated thin film has a large critical current density in the direction in parallel to the substrate surface.

It is desired that the abovementioned oxide superconductor is a high-T_{c}(high critical temperature) oxide superconductor. This high-T_{c} oxide superconductor has been studied by many researchers since the discovery of Bednorz and Müller in 1986, and is said to have a superconducting critical temperature of not less than 30K. More specifically, the oxide superconductor is a high-T_{c} copper-oxide type compound oxide superconductor including a Y-Ba-Cu-O type compound oxide superconductor, a Bi-Sr-Ca-Cu-O type compound oxide superconductor and a Tl-Ba-Ca-Cu-O type compound oxide superconductor.

In addition, the substrate, on which the oxide superconductor layer is deposited, can be formed of an insulating substrate, preferably an oxide single crystalline substrate such as MgO, SrTiO₃, CdNdAlO₄, YSZ (yttrium stabilized zirconia) etc. These substrate materials are very effective in forming or growing a crystalline film having a good superconducting property and have characteristics which are suitable for the present invention.

According to another aspect of the present invention, there is provided a superconducting device comprising a substrate having a principal surface and a projecting portion on the principal surface and an oxide superconductor region having a planar upper surface formed on the principal surface of which thickness of a portion at said projecting portion is reduced, characterized in that the projecting portion of the substrate is an etch projection having a crystallographically specified shape resulting from a lattice defect previously formed at and below the principal surface of the substrate, at said projecting portion.

The reduced thickness portion within the oxide superconductor thin film positioned on the projecting portion of the substrate can form a weak-link of a Josephson junction.

Further, there is provided a superconducting device comprising a substrate having a principal surface and a projecting portion on the principal surface, an oxide superconductor region having a planar upper surface formed on the principal surface of which thickness of a portion at said projecting portion is reduced, a first and a second electrodes arranged on the upper surface of the oxide superconductor region at both sides of the reduced thickness portion and a weak-link of a Josephson junction formed at the reduced thickness portion of the oxide superconductor region, characterized in that the projecting portion of the substrate is an etch projection having a crystallographically specified shape resulting from a lattice defect previously formed at and below the principal surface of the substrate, at said projecting portion.

There is also provided a superconducting device comprising a substrate having a principal surface and a projecting portion on the principal surface, an oxide superconductor region having a planar upper surface formed on the principal surface of which thickness of a portion at said projecting portion is reduced, a first and a second electrodes arranged on the upper surface of the oxide superconductor region at both sides of the reduced thickness portion, and a third electrode arranged above the reduced thickness portion of the oxide superconductor region on an insulator layer so that superconducting current can flow between the first and second electrodes, which can be controlled by a voltage applied to the third electrode, characterized in that the projecting portion of the substrate is formed as an etch projection having a crystallographically specified shape resulting from a lattice defect previously formed at and below the principal surface of the substrate, at said projecting portion.

The above and other objects, features and advantages of the present invention will be apparent from the following description of preferred embodiments of the invention with reference to the accompanying drawings.

### Brief Description of the Drawings

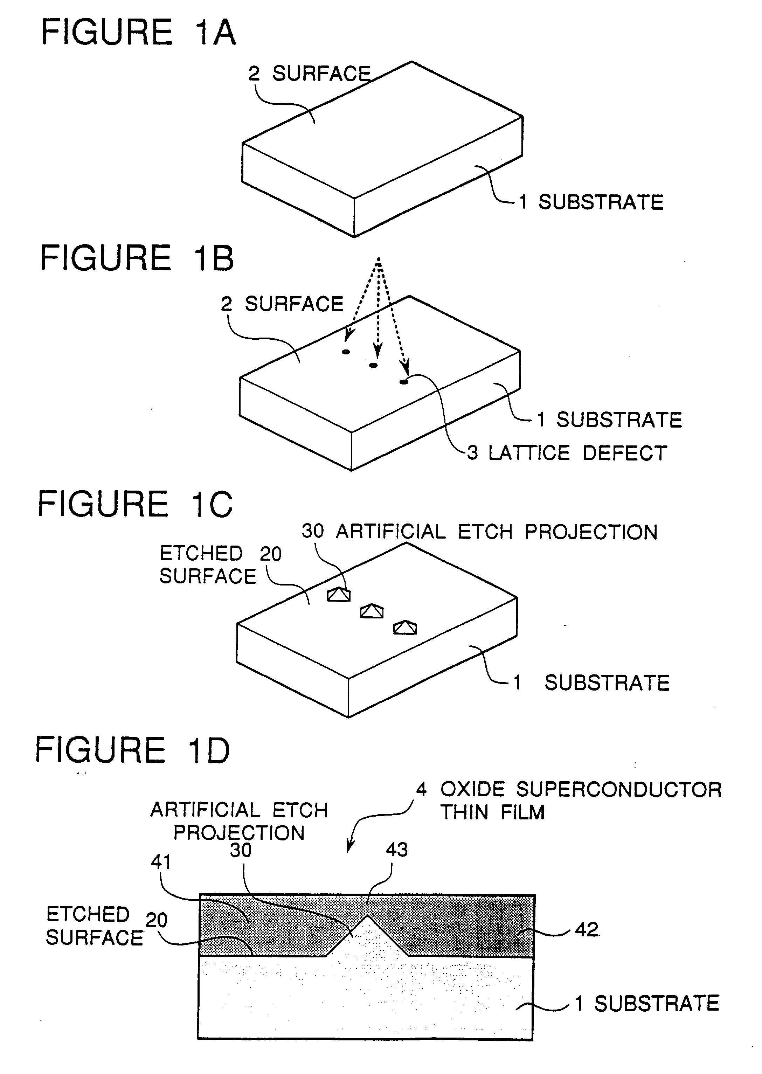

Figures 1A to 1EE are diagrammatic views for illustrating an embodiment of the process in accordance with the present invention for manufacturing the superconducting device.

### Description of the Preferred embodiments

Referring to Figures 1A to 1EE, an embodiment of the process in accordance with the present invention for manufacturing the superconducting device will be described.

As shown in Figure 1A, there was prepared an MgO (100) substrate 1 having a principal surface 2. The substrate 1 was heated up to a temperature of 1100 °C under an oxygen atmosphere for eight hours. After the heat-treatment, little lattice defect was found on the principal surface 2. If there was no lattice defect on the principal surface, the heat-treatment was not necessary.

As shown in Figure 1B, argon ions were ion-implanted in a center portion of the principal surface 2 so that lined lattice defects 3 were formed. The condition for the argon ion-implantation was that the acceleration energy was 75 keV and the dose was 1 × 10¹⁴ to 1 × 10¹⁶ ions/cm².

Then, the principal surface 2 of the substrate 1 was etched by H₃PO₄ so that artificial etch projections 30 of a quadrangular pyramid shape were formed on the etched principal surface 20; as shown in Figure 1C. The artificial etch projections 30 were formed since the lattice defects of the crystalline surface were hardly etched by H₃PO₄. Almost all crystalline solids more or less have this property. If the crystallinity of the etched principal surface 20 was decreased, the heat-treatment was carried out again.

Thereafter, Y₁Ba₂Cu₃O_{7-δ} oxide superconductor thin film 4 having a thickness of 300 nanometers was deposited on the etched principal surface 20 by for example an off-axis sputtering, a reactive evaporation, an MBE, a CVD, etc, as shown in Figure 1D. The condition of forming the Y₁Ba₂Cu₃O_{7-δ} oxide superconductor thin film 4 by off-axis sputtering was as follows:

| | |
|---|---|
| Sputtering Gas | Ar: 90% |
| | O₂: 10% |
| Total pressure | 6.665 Pa (5 × 10⁻² Torr) |
| Temperature of the substrate | 700°C |

In order to planarize an upper surface of the deposited oxide superconductor thin film 4, a photoresist layer (not shown) was deposited on the oxide superconductor thin film 4 in such a manner that the deposited photoresist layer had a flat upper surface, and then, the deposited photoresist layer and the deposited oxide superconductor thin film 4 were etched back, until the upper surface of the oxide superconductor thin film 4 was planarized, as shown in Figure 1D. Then, the oxide superconductor thin film in accordance with the present invention was completed. The oxide superconductor thin film 4 was formed of uniform *c*-axis orientated Y₁Ba₂Cu₃O_{7-δ} oxide superconductor crystals and had a first and a second superconducting portions 41 and 42 having a rather large thickness and a third superconducting portion 43 having a reduced thickness above the artificial etch projections 30. It was possible to form a weak-link of a Josephson junction in the third superconducting portion 43 by controlling its thickness.

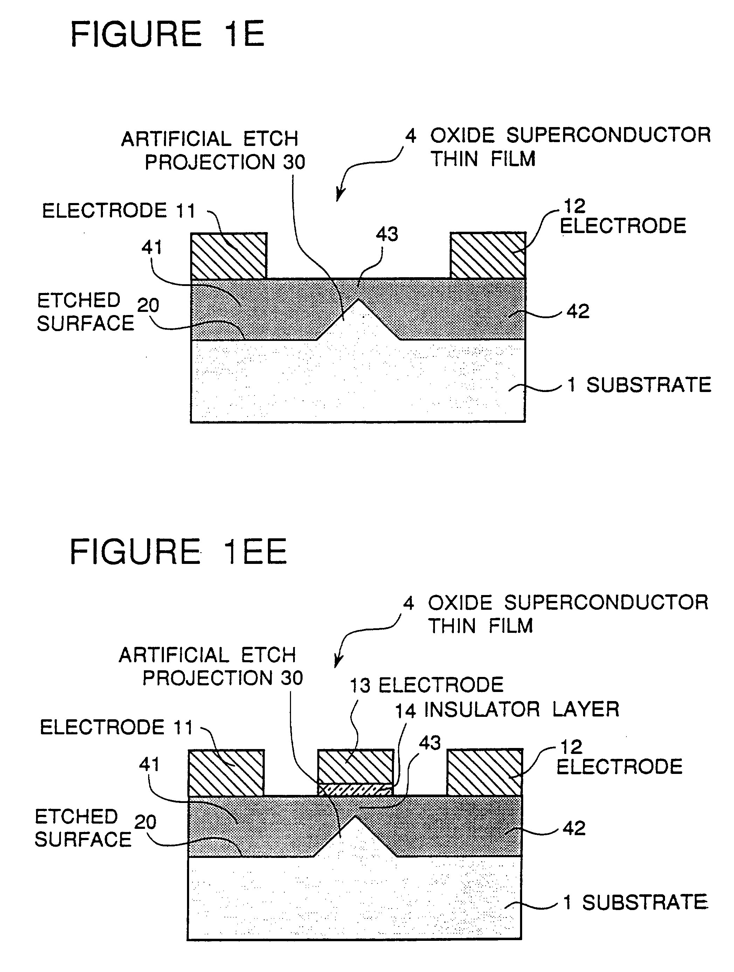

Then, if there was a weak-link of a Josephson junction in the third superconducting portion 43, a first and a second electrodes 11 and 12 of Au were formed on the first and the second superconducting portions 41 and 42, as shown in Figure 1E and the superconducting device in accordance with the present invention was completed. In this case, the superconducting device was a weak-link type Josephson device.

If there was not a weak-link in the third superconducting portion 43 and a superconducting channel was formed, a first and a second electrodes 11 and 12 of Au were formed on the first and the second superconducting portions 41 and 42, and an insulator layer 14 and a third electrode of Au were formed on the third superconducting portion 43, as shown in Figure 1EE and the other superconducting device in accordance with the present invention was completed. In this case, the superconducting device was an FET type superconducting device in which superconducting current flowing between the first and the second superconducting portions 41 and 42 through the third superconducting portion 43 was controlled by a voltage applied to the third electrode 13.

As explained above, if the superconducting thin film is manufactured in accordance with the above mentioned process, an oxide superconductor thin film can be formed on a substrate having a projecting portion which is not contaminated by photoresist or photoresist remover. Therefore, the superconductivity of the oxide superconductor is not spoiled. The superconducting thin film is applicable to a weak-link type Josephson device and a super-FET. Accordingly, it is easy to manufacture the superconducting devices with good repeatability, and the manufactured superconducting devices have stable characteristics.

In the above mentioned embodiments, the oxide superconductor thin film can be formed of not only the Y-Ba-Cu-O type compound oxide superconductor material, but also a high-T_{c} (high critical temperature) oxide superconductor material, particularly a high-T_{c} copper-oxide type compound oxide superconductor material, for example a Bi-Sr-Ca-Cu-O type compound oxide superconductor material, and a Tl-Ba-Ca-Cu-O type compound oxide superconductor material.

The invention has thus been shown and described with reference to the specific embodiment. However, it should be noted that the present invention is in no way limited to the details of the illustrated structures but converts and modifications may be made within the scope of the appended claims.

## Claims

1. A method of manufacturing a superconducting thin film having at least one reduced thickness portion, the method comprising the step of:
ion-implanting onto a principal surface (2) of a crystalline substrate (1) thereby forming a lattice defect (3) at and below the principal surface (2) of the substrate (1),
etching the principal surface (2) of the substrate (1) by a wet-etching process so that the portion of the lattice defect (3) is etched thereby forming a projecting portion (30) having a crystallographically specified shape, and
forming an oxide superconductor thin film (4) having a planar upper surface on the etched principal surface (20) of the substrate (1) so that a portion (43) of the oxide superconductor thin film (4) at the projecting portion (30) of the substrate (1) has a reduced thickness.

2. The method claimed in Claim 1, **characterized in that** the substrate (1) is heated under oxygen atmosphere at a temperature ranging from 1050 to 1500°C for 5 to 10 hours before the ion-implantation in order to eliminate lattice defects from its principal surface (2).

3. The method claimed in Claim 2, **characterized in that** the substrate (1) is heated under oxygen atmosphere at a temperature of 1100 °C for 8 hours before the ion-implantation in order to eliminate lattice defects from its principal surface (2).

4. The method claimed in anyone of Claims 1 to 3, **characterized in that** the substrate (1) is heated under oxygen atmosphere at a temperature ranging from 1050 to 1500°C for 5 to 10 hours after the etching in order to improve crystallinity of its etched principal surface (20).

5. The method claimed in Claim 4, **characterized in that** the substrate (1) is heated under oxygen atmosphere at a temperature of 1100 °C for 8 hours after the etching in order to improve crystallinity of its etched principal surface (20).

6. The method claimed in anyone of Claims 1 to 5, **characterized in that** the ions which are ion-implanted are selected from argon ions, neon ions and oxygen ions.

7. The method claimed in anyone of Claims 1 to 6, **characterized in that** the ions are ion-implanted by a focused ion beam apparatus.

8. The method claimed in anyone of Claims 1 to 7, **characterized in that** the principal surface (2) of the substrate (1) is etched by H₃PO₄ or HCl.

9. The method claimed in anyone of Claims 1 to 8, **characterized in that** the oxide superconductor thin film (4) is a c-axis orientated oxide superconductor thin film.

10. The method claimed in anyone of Claims 1 to 9, **characterized in that** the oxide superconductor thin film (4) is formed of high-T_{c} (high critical temperature) oxide superconductor, particularly, formed of a high-T_{c} copper-oxide type compound oxide superconductor.

11. The method claimed in Claim 10, **characterized in that** the oxide superconductor thin film (4) is formed of oxide superconductor material selected from the group consisting of a Y-Ba-Cu-O type compound oxide superconductor material, a Bi-Sr-Ca-Cu-O type compound oxide superconductor material, and a Tl-Ba-Ca-Cu-O type compound oxide superconductor material.

12. The method claimed in anyone of Claims 1 to 11, **characterized in that** the substrate (1) is formed of a material selected from the group consisting of a MgO (100) substrate, a SrTiO₃ (100) substrate, a CdNdAlO₄ (001) substrate and a YSZ substrate.

13. A superconducting device comprising a substrate (1) having a principal surface (20) and a projecting portion (30) on the principal surface (20), and an oxide superconductor region (4) having a planar upper surface formed on the principal surface (20) of which thickness of a portion (43) at said projecting portion is reduced, **characterized in that** the projecting portion (30) of the substrate (1) is an etch projection having a crystallographically specified shape resulting from a lattice defect (3) previously formed at and below the principal surface (2) of the substrate (1), at said projecting portion.

14. A superconducting device claimed in Claim 13, **characterized in that** the reduced thickness portion (43) of the oxide superconductor region positioned at the projecting portion (30) of the substrate (1) forms a weak-link of a Josephson junction.

15. The superconducting device claimed in claim 13 further comprising a first and a second electrodes (11, 12) arranged on the upper surface of the oxide superconductor region (4) at both sides of the reduced thickness portion (43), and a weak-link of a Josephson junction formed at the reduced thickness portion (43) of the oxide superconductor region (4).

16. The superconducting device claimed in claim 13 further comprising a first and a second electrodes (11, 12) arranged on the upper surface of the oxide superconductor region (4) at the both sides of the reduced thickness portion (43), and a third electrode (13) arranged above the reduced thickness portion (43) of the oxide superconductor region (4) on an insulator layer (14) so that superconducting current can flow between the first and second electrodes (11, 12), which can be controlled by a voltage applied to the third electrode (13).

## Patentansprüche

1. Verfahren zum Herstellen einer supraleitenden Dünnschicht mit zumindest einem Abschnitt verringerter Dicke, wobei das Verfahren die Schritte aufweist:
Implantieren von Ionen auf einer Hauptfläche (2) eines kristallinen Substrats (1), wodurch ein Gitterdefekt (3) an sowie unter der Hauptfläche (2) des Substrats (1) gebildet wird,
Ätzen der Hauptfläche (2) des Substrats (1) durch einen Naßätzprozeß derart, daß der Abschnitt des Gitterdefekts (3) geätzt wird, wodurch ein vorspringender Abschnitt (30) mit einer kristallographisch festgelegten Form gebildet wird, und
Bilden einer oxidischen supraleitenden Dünnschicht (4) mit einer planaren Oberseite auf der geätzten Hauptfläche (20) des Substrats (1) derart, daß ein Abschnitt (43) der oxidischen supraleitenden Dünnschicht (4) am vorspringenden Abschnitt (30) des Substrats (1) eine verringerte Dicke aufweist.

2. Verfahren nach Anspruch 1, dadurch gekennzeichnet, daß das Substrat (1) unter Sauerstoffatmosphäre bei einer Temperatur im Bereich von 1050 bis 1500°C für 5 bis 10 Stunden vor der Ionenimplantation erhitzt wird, um Gitterdefekte von seiner Hauptfläche (2) zu eliminieren.

3. Verfahren nach Anspruch 2, dadurch gekennzeichnet, daß das Substrat (1) unter Sauerstoffatmosphäre bei einer Temperatur von 1100°C für 8 Stunden vor der Ionenimplantation erhitzt wird, um Gitterdefekte von seiner Hauptfläche (2) zu eliminieren.

4. Verfahren nach einem der Ansprüche 1 bis 3, dadurch gekennzeichnet, daß das Substrat (1) unter Sauerstoffatmosphäre bei einer Temperatur im Bereich von 1050 bis 1500°C für 5 bis 10 Stunden nach dem Ätzen erhitzt wird, um die Kristallinität seiner geätzten Hauptfläche (20) zu verbessern.

5. Verfahren nach Anspruch 4, dadurch gekennzeichnet, daß das Substrat (1) unter Sauerstoffatmosphäre bei einer Temperatur von 1100°C für 8 Stunden nach dem Ätzen erhitzt wird, um die Kristallinität seiner geätzten Hauptfläche (20) zu verbessern.

6. Verfahren nach einem der Ansprüche 1 bis 5, dadurch gekennzeichnet, daß die Ionen, die ionenimplantiert werden, aus Argonionen, Neonionen und Sauerstoffionen gewählt werden.

7. Verfahren nach einem der Ansprüche 1 bis 6, dadurch gekennzeichnet, daß die Ionen durch eine fokussierte Ionenstrahlvorrichtung ionenimplantiert werden.

8. Verfahren nach einem der Ansprüche 1 bis 7, dadurch gekennzeichnet, daß die Hauptfläche (2) des Substrats (1) durch H₃PO₄ oder HCl geätzt wird.

9. Verfahren nach einem der Ansprüche 1 bis 8, dadurch gekennzeichnet, daß die oxidische supraleitende Dünnschicht (4) eine c-Achsen-orientierte oxidische supraleitende Dünnschicht ist.

10. Verfahren nach einem der Ansprüche 1 bis 9, dadurch gekennzeichnet, daß die oxidische supraleitende Dünnschicht (4) aus einem oxidischen Supraleiter mit hoher T_{c} (hoher kritischer Temperatur), insbesondere aus einem supraleitenden Kupferoxid-Verbundoxid mit hoher T_{c} gebildet ist.

11. Verfahren nach Anspruch 10, dadurch gekennzeichnet, daß die oxidische supraleitende Dünnschicht (4) aus einem oxidischen Supraleiter gebildet wird, der aus der Gruppe ausgewählt wird, die aus einem supraleitenden Y-Ba-Cu-O-Verbundoxid, einem supraleitenden Bi-Sr-Ca-Cu-O-Ver-bundoxid und einem supraleitenden Tl-Ba-Ca-Cu-O-Ver-bundoxid besteht.

12. Verfahren nach einem der Ansprüche 1 bis 11, dadurch gekennzeichnet, daß das Substrat (1) aus einem Material gebildet wird, das aus der Gruppe gewählt wird, die aus einem MgO(100)-Substrat, einem SrTiO₃(100)-Substrat, einem CdNdAlO₄(001)-Substrat und einem YSZ-Substrat besteht.

13. Supraleitende Einrichtung, aufweisend ein Substrat (1) mit einer Hauptfläche (20) und einem vorspringenden Abschnitt (30) auf der Hauptfläche (20) und einen oxidischen supraleitenden Bereich (4) mit einer planaren Oberseite, gebildet auf der Hauptfläche (20), wobei die Dicke eines Abschnitts (43) am vorspringenden Abschnitt verringert ist, dadurch gekennzeichnet, daß der vorspringende Abschnitt (30) des Substrats (1) ein Ätzvorsprung mit einer kristallographisch festgelegten Form resultierend aus einem Gitterdefekt (3) ist, der vorausgehend an sowie unter der Hauptfläche (2) des Substrats (1) an dem vorspringenden Abschnitt gebildet wurde.

14. Supraleitende Einrichtung nach Anspruch 13, dadurch gekennzeichnet, daß der Abschnitt (43) verringerter Dicke des oxidischen supraleitenden Bereichs, der an dem vorspringenden Abschnitt (30) des Substrats (1) positioniert ist, eine schwache Verknüpfung eines Josephson-Übergangs bildet.

15. Supraleitende Einrichtung nach Anspruch 13, außerdem aufweisend eine erste und eine zweite Elektrode (11, 12), die auf der Oberseite des oxidischen supraleitenden Bereichs (4) zu beiden Seiten des Abschnitts (43) verringerter Dicke angeordnet sind, und eine schwache Verknüpfung eines Josephson-Übergangs, der an dem Abschnitt (43) verringerter Dicke des oxidischen supraleitenden Bereichs (4) gebildet ist.

16. Supraleitende Einrichtung nach Anspruch 13, außerdem aufweisend eine erste und eine zweite Elektrode (11, 12), die auf der Oberseite des oxidischen supraleitenden Bereichs (4) zu beiden Seiten des Abschnitts (43) verringerter Dicke angeordnet sind, und eine dritte Elektrode (13), die über dem Abschnitt (43) verringerter Dicke des oxidischen supraleitenden Bereichs (4) auf einer isolierenden Schicht (14) derart angeordnet ist, daß der supraleitende Strom zwischen den ersten und zweiten Elektroden (11, 12) fließen kann, der durch eine an die dritte Elektrode (13) angelegte Spannung gesteuert ist.

## Revendications

1. Procédé pour fabriquer un film mince supraconducteur possédant au moins une partie d'épaisseur réduite, le procédé comprenant les étapes consistant à :
exécuter une implantation ionique sur une surface principale (2) d'un substrat cristallin (1), en formant ainsi un défaut de réseau (3) au niveau et au-dessous de la surface principale (2) du substrat (1),
attaquer la surface principale (2) du substrat (1) au moyen d'un processus d'attaque par voie humide de manière que la partie du défaut de réseau (3) soit attaquée en formant ainsi une partie saillante (30) ayant une forme spécifiée du point de vue cristallographique, et
former un film mince d'oxyde supraconducteur (4) possédant une surface supérieure plane sur la surface principale attaquée (20) du substrat (1) de telle sorte qu'une partie (43) du film mince d'oxyde supraconducteur (4) au niveau de la partie saillante (30) du substrat (1) possède une épaisseur réduite.

2. Procédé selon la revendication 1, caractérisé en ce que le substrat (1) est chauffé dans une atmosphère d'oxygène à une température comprise entre 1050 et 1500°C pendant 5 à 10 heures avant l'implantation ionique de manière à supprimer les défauts de réseau dans sa surface principale (2).

3. Procédé selon la revendication 2, caractérisé en ce que le substrat (1) est chauffé dans une atmosphère d'oxygène à une température de 1100°C pendant 8 heures avant l'implantation ionique de façon à supprimer les défauts du réseau dans sa surface principale (2).

4. Procédé selon l'une quelconque des revendications 1 à 3, caractérisé en ce que le substrat (1) est chauffé dans une atmosphère d'oxygène à une température comprise entre 1050 et 1500°C pendant 5 à 10 heures après l'attaque de manière à améliorer la cristallinité de sa surface principale attaquée (20).

5. Procédé selon la revendication 4, caractérisé en ce que le substrat (1) est chauffé dans une atmosphère d'oxygène à une température de 1100°C pendant 8 heures après l'attaque de manière à améliorer la cristallinité de sa surface principale attaquée(20).

6. Procédé selon l'une quelconque des revendications 1 à 5, caractérisé en ce que les ions, qui sont implantés, sont choisis parmi des ions argon, les ions néon et des ions oxygène.

7. Procédé selon l'une quelconque des revendications 1 à 6, caractérisé en ce que les ions sont implantés au moyen d'un appareil à faisceau d'ions focalisé.

8. Procédé selon l'une quelconque des revendications 1 à 7, caractérisé en ce que la surface principale (2) du substrat (1) est attaquée par H₃PO₄ ou HCl.

9. Procédé selon l'une quelconque des revendications 1 à 8, caractérisé en ce que le film mince d'oxyde supraconducteur (4) est un film mince d'oxyde supraconducteur orienté suivant l'axe c.

10. Procédé selon l'une quelconque des revendications 1 à 9, caractérisé en ce que le film mince d'oxyde supraconducteur (4) est formé d'un oxyde supraconducteur à température T_{c} élevée (température critique élevée), et notamment est formé d'un oxyde mixte supraconducteur du type oxyde de cuivre à température T_{c} élevée.

11. Procédé selon la revendication 10, caractérisé en ce que le film mince d'oxyde supraconducteur (4) est formé d'un matériausupraconducteur d'oxyde choisi dans le groupe comprenant un matériau supraconducteur formé d'un oxyde mixte du type Y-Ba-Cu-O, un matériau supraconducteur formé d'un oxyde mixte du type Bi-Sr-Ca-Cu-O et un matériau supraconducteur formé d'un oxyde mixte du type Tl-Ba-Ca-Cu-O.

12. Procédé selon l'une quelconque des revendications 1 à 11, caractérisé en ce que le substrat (1) est formé d'un matériau choisi dans le groupe comprenant un substrat en MgO (100), un substrat en SrTiO₃ (100), un substrat en CdNdAlO₄ (001) et un substrat en YSZ.

13. Dispositif supraconducteur comprenant un substrat (1) possédant une surface principale (20) et une partie saillante (30) sur la surface principale (20), et une région d'oxyde supraconducteur (4) possédant une surface supérieure plane formée sur la surface principale (20) et dont l'épaisseur d'une portion (43) au niveau de ladite partie saillante est réduite, caractérisé en ce que la partie saillante (30) du substrat (1) est une partie saillante formée par attaque et possédant une forme spécifique du point de vue cristallographique résultant d'un défaut de réseau (3) formé au préalable au niveau et au-dessous de la surface principale (2) du substrat (1), au niveau de ladite partie saillante.

14. Dispositif supraconducteur selon la revendication 13, caractérisé en ce que la portion d'épaisseur réduite (43) de la région d'oxyde supraconducteur située au niveau de la partie saillante (30) du substrat (1) forme une liaison faible d'une jonction Josephson.

15. Dispositif supraconducteur selon la revendication 13, comprenant en outre des première et seconde électrodes (11, 12), disposées sur la surface supérieure de la région d'oxyde supraconducteur (4) des deux côtés de la portion d'épaisseur réduite (43), et une liaison faible d'une jonction Josephson formée au niveau de la portion d'épaisseur réduite (43) de la région d'oxyde supraconducteur (4).

16. Dispositif supraconducteur selon la revendication 13, comprenant en outre des première et seconde électrodes (11, 12) disposées sur la surface supérieurede la région d'oxyde supraconducteur (4) des deux côtés de la portion d'épaisseur réduite (43), et une troisième électrode (13) disposée au-dessus de la portion d'épaisseur réduite (43) de la région d'oxyde supraconducteur (4) sur une couche isolante (14) de sorte qu'entre les première et seconde électrodes (11, 12), peut circuler un courant de supraconduction qui peut être commandé par une tension appliquée à la troisième électrode (13).
